# EUROPEAN PATENT SPECIFICATION

(11) **EP 4 524 827 B1**
(45) Date of publication and mention of the grant of the patent: **08.07.2026**
(21) Application number: 24199176.9
(22) Date of filing: 09.09.2024
(51) Int. Cl.: G06N 10/40, H03H 7/01

(54) **QUANTUM DEVICE**
QUANTENVORRICHTUNG
DISPOSITIF QUANTIQUE

(30) Priority: 14.09.2023 JP 2023149424
(43) Date of publication of application: 19.03.2025
(73) Proprietor: FUJITSU LIMITED, Kawasaki-shi, Kanagawa 211-8588 (JP); RIKEN, Wako-shi, Saitama 351-0198 (JP)
(72) Inventor: KAWASHITA, Mitsuya, Kawasaki-shi, Kanagawa, 211-8588 (JP); TAMATE, Shuhei, Wako-shi, Saitama, 351-0198 (JP)
(74) Representative: Hoffmann Eitle

(56) References cited:
- BRONN NICHOLAS T ET AL: "Reducing Spontaneous Emission in Circuit Quantum Electrodynamics by a Combined Readout/Filter Technique", IEEE TRANSACTIONS ON APPLIED SUPERCONDUCTIVITY, IEEE, USA, vol. 25, no. 5, 1 October 2015 (2015-10-01), pages 1 - 10, XP011667869, ISSN: 1051-8223, [retrieved on 20150902], DOI: 10.1109/TASC.2015.2456109

## Description

### FIELD

The embodiments discussed herein are related to quantum devices.

### BACKGROUND

In a quantum computer using superconducting quantum bits (hereinafter, also simply referred to as a "qubits"), there is a known method of performing a two-qubit gating operation. In order to control the qubit, the qubit is coupled to a waveguide, and a microwave pulse is irradiated from the waveguide. The stronger the coupling between the qubit and the waveguide is, the shorter the time (or gating time) required to perform the qubit gating operation becomes. On the other hand, the stronger the coupling between the qubit and the waveguide is, the shorter the quantum lifetime (or quantum coherence) of the qubit becomes. That is, increasing the quantum lifetime of the quantum bit and reducing the gating time are in a mutually contradictory relationship, as explained in International Publication Pamphlet No. WO 2020/105732, for example.

In a two-qubit gating (also referred to as a cross resonance gating), a signal having a frequency at which a target qubit resonates is input from the waveguide to a control qubit, such that a state of the target qubit changes according to a state of the control qubit.

In the case of the two-qubit gating, the gating can be speeded up (that is, the gating time can be shortened) by increasing an intensity of the signal input to the control qubit or increasing a coupling efficiency between the waveguide and the qubit. However, if the coupling between the control qubit and the input waveguide is too strong, a radiation loss from the control qubit to the input waveguide increases, and a coherence time (or data retention time) of the control qubit is shortened.

Further, from Bronn et al.: "Reducing Spontaneous Emission in Circuit Quantum Electrodynamics by a Combined Readout/Filter Technique", a method integrating filtering techniques for preserving superconducting qubits lifetimes together with the dispersive coupling of the qubit to a microwave resonator for control and measurement is known.

### SUMMARY

Accordingly, it is an object in one aspect of the embodiments to provide a quantum device capable of securing a quantum gating speed and a coherence time.

According to one aspect of the embodiments, a quantum device includes a highpass filter having a plurality of notches in a first frequency band lower than a second frequency band, wherein a coupling efficiency of the highpass filter in the second frequency band is higher than a coupling efficiency of the highpass filter in the first frequency band (W1; a first qubit that resonates at a first resonant frequency included in the first frequency band; and a second qubit that resonates at a second resonant frequency included in the second frequency band, wherein the first qubit is input with a signal having a frequency at which the first qubit resonates via the highpass filter to control a state of the first qubit when executing a one-qubit gating, and is input with a signal having a frequency at which the second qubit resonates via the highpass filter to control a state of the second qubit according to a quantum state of the first qubit when executing a two-qubit gating, and wherein the first qubit is a control qubit, and the second qubit is a target qubit.

It is to be understood that both the foregoing general description and the following detailed description are exemplary and explanatory and are not restrictive. The scope of the invention is defined by the appended claims.

### BRIEF DESCRIPTION OF DRAWINGS

FIG. 1 is a diagram illustrating a connection example of qubits;
FIG. 2 is a diagram for explaining a frequency dependence of a coupling efficiency between a waveguide and a control qubit;
FIG. 3 is a diagram for explaining a quantum device according to one embodiment;
FIG. 4 is a diagram illustrating an example of a frequency characteristic of the coupling efficiency of a filter;
FIG. 5 is a perspective view illustrating a configuration example of the quantum device according to a first embodiment;
FIG. 6 is an equivalent circuit diagram of the quantum device according to the first embodiment;
FIG. 7 is a plan view illustrating a configuration example of the quantum device according to a second embodiment;
FIG. 8 is an equivalent circuit diagram of the quantum device according to the second embodiment; and
FIG. 9 is a diagram for explaining a frequency characteristic of the coupling efficiency of the filter and resonance frequencies of qubits.

### DESCRIPTION OF EMBODIMENTS

Preferred embodiments of the present invention will be described with reference to the accompanying drawings.

A quantum device according to one aspect that does not fall within the scope of the appended claims includes a filter for correcting a level difference between signals required for a one-qubit gating and a two-qubit gating, which are input to each qubit, at each resonance frequency of a control qubit that resonates in a low frequency band and a target qubit that resonates in a high frequency band, in order to implement a quantum logic gate of a quantum computer. The quantum computer includes a one-qubit logic gate such as a Pauli gate or the like, and a two-qubit logic gate such as a controlled Pauli-X gate (or CNOT gate) or the like, and performs a computation using these qubit logic gates. The CNOT gate is used for generating a state of quantum entanglement or the like.

A cross resonance gating is an example of a configuration for inducing the quantum entanglement. The cross resonance gating has a control qubit adjacent to an input end, and a target qubit to be coupled to the control qubit. The control qubit and the target qubit have mutually different resonance frequencies.

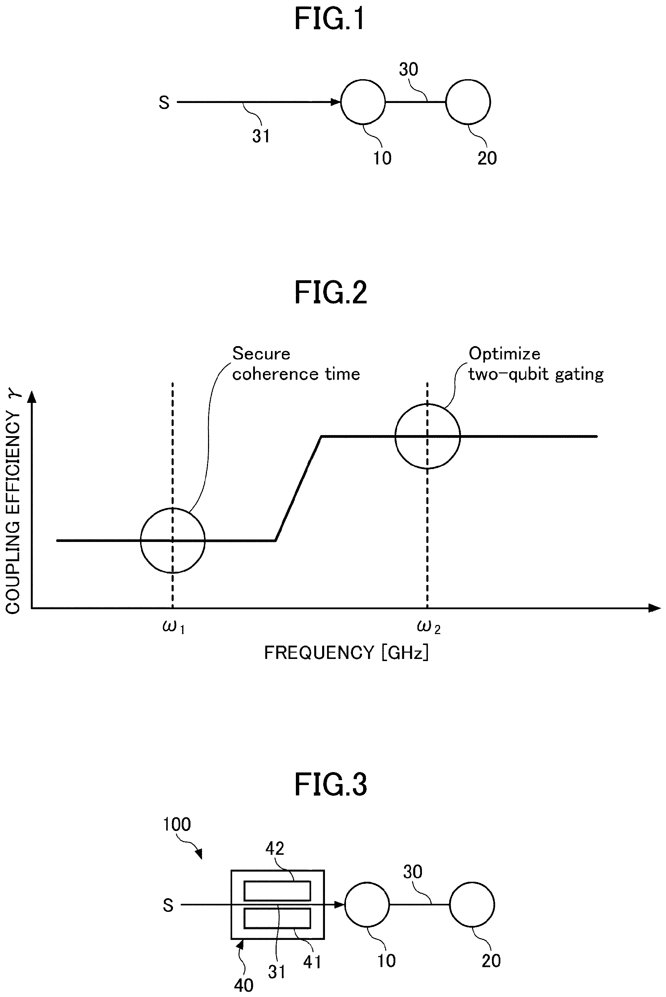

FIG. 1 is a diagram illustrating a connection example of qubits. A control signal S for driving a two-qubit gating (or cross resonance gating) in which a control qubit 10 and a target qubit 20 are coupled, is input to the control qubit 10.

In the cross resonance gating, the control signal S having a frequency identical to a resonance frequency (or resonant frequency) of the target qubit 20 is input to the control qubit 10, in order to induce the quantum entanglement between the control quantum bit 10 and the target qubit 20 that are mutually adjacent. Hence, a state of the target qubit 20 changes according to a quantum state of the control qubit 10. The control signal S is, for example, a microwave.

In the case of the cross resonance gating in which the control qubit 10 resonating in a low frequency band and the target qubit 20 resonating in a high frequency band are coupled, the gating can be speeded up (the gating time can be shortened) by increasing an intensity of the control signal S input from a waveguide 31 to the control qubit 10 or increasing a coupling efficiency of the control signal S from the waveguide 31 to the control qubit 10. However, if the coupling intensity between the waveguide 31 and the control qubit 10 is too large, a coherence time (or data retention time) of the control qubit 10 is shortened.

Hence, the quantum device according to the present discussed aspect (not covered by the scope of the appended claims) includes a filter structure in which a coupling efficiency γ between the waveguide 31 and the control qubit 10 has a frequency dependence illustrated in FIG. 2. The coupling efficiency γ represents a ratio of an intensity of the control signal S input from the waveguide 31 to the control qubit 10 with respect to an intensity of the control signal S input to the waveguide 31. The intensity of the control signal S is represented by a magnitude of a power of the control signal S, for example. The filter structure according to the present embodiment has a coupling characteristic such that the coupling efficiency γ in a second frequency band including a frequency (resonant frequency ω₂) at which the target qubit 20 resonates is high compared to the coupling efficiency γ in a first frequency band including a frequency (resonant frequency ω₁) at which the control qubit 10 resonates.

Because the coupling efficiency γ is high at the resonant frequency ω₂, the control signal S having a relatively high intensity at the resonant frequency ω₂ is input to the control qubit 10, and thus, it is possible to speed up the two-qubit gating between the control qubit 10 and the target qubit 20. On the other hand, because the coupling efficiency γ is low at the resonant frequency ω₁, it is possible to reduce a radiation loss from the control qubit 10 to the waveguide 31 at the resonant frequency ω₁, and reduce shortening of the coherence time of the control qubit 10. Accordingly, it is possible to provide a two-qubit gating capable of securing the quantum gating speed and the coherence time.

For example, by adopting a filter structure having a high coupling efficiency γ at the resonant frequency ω₂, the quantum gating speed can be secured compared to a case where such a filter structure is not adopted, even if the power of the control signal S input to the waveguide 31 at the resonant frequency ω₂ is reduced. By reducing the power of the control signal S input to the waveguide 31 at the resonant frequency ω₂, it is possible to achieve a reduced power consumption.

For example, the power of the control signal S at the resonant frequency ω₂ can be reduced to the power of the control signal S at the resonant frequency ω₁. It is advantageous for digital generation of the control signal S when the power of the control signal S at the resonant frequency ω₂ and the power of the control signal S at the resonant frequency ω₁ become equal. For example, if signals having a large level difference are created using a single digital-to-analog converter (DAC), a dynamic range of the signals becomes narrow, and a quality of the signals may deteriorate. On the other hand, if such signals having the large level difference are created using a plurality of DACs, a number of required components or parts increases, and cause an increase in the size and cost of the device for generating the control signal S. In contrast, when the power of the control signal S at the resonant frequency ω₂ and the power of the control signal S at the resonant frequency ω₁ become equal, it is possible to reduce the deterioration of the signal quality caused by an insufficient dynamic range, even when the control signal S is generated using a single DAC.

A quantum device 100 according to the present embodiment illustrated in FIG. 3 includes a highpass filter 40 in a stage preceding the control qubit 10. The highpass filter has a coupling characteristic in which the coupling efficiency γ in a second frequency band including the resonant frequency ω₂ is higher than the coupling efficiency γ in a first frequency band including the resonant frequency ω₁.

FIG. 3 is a diagram illustrating a configuration example of the quantum device according to the present embodiment. The quantum device 100 illustrated in FIG. 3 includes the highpass filter 40 that transmits the control signal S in the first frequency band with the coupling efficiency γ lower than that in the second frequency band, the control qubit 10 that resonates in the first frequency band, and the target qubit 20 that resonates in the second frequency band. The quantum device 100 is a cross resonance gating in which the control qubit 10 and the target qubit 20 are coupled via a transmission line 30, for example.

The highpass filter 40 is a filter that transmits a signal in a first frequency band with a coupling efficiency γ lower than that in a second frequency band. The control qubit 10 is an example of a first qubit that resonates in the first frequency band. The target qubit 20 is an example of a second qubit that resonates in the second frequency band.

When implementing a one-qubit gating, a signal having a frequency at which the control qubit 10 resonates is input to the control qubit 10 via the highpass filter 40, thereby controlling a quantum state of the control qubit 10. When implementing a two-qubit gating, the control signal S having a frequency at which the target qubit 20 resonates is input to the control qubit 10 via the highpass filter 40. As a result, a state of the target qubit 20 changes according to the quantum state of the control qubit 10.

The highpass filter 40 included in the quantum device 100 according to the present embodiment has a plurality of notches in a low frequency band (the first frequency band in which the coupling efficiency γ is reduced more than in the second frequency band) including the resonance frequency of the control qubit 10. Hence, it is possible to secure the first frequency band in which the coupling efficiency γ is reduced more than in the second frequency band to have a width that is wide to a certain extent. Because the wide width of the first frequency band can be secured, a coupling efficiency characteristic of the highpass filter 40 in the first frequency band can be made to approximate a flat characteristic. As a result, even when the frequency at which the control qubit 10 resonates is shifted due to manufacturing variations or the like, it is possible to stabilize the operation of the quantum device 100 (cross resonance gating).

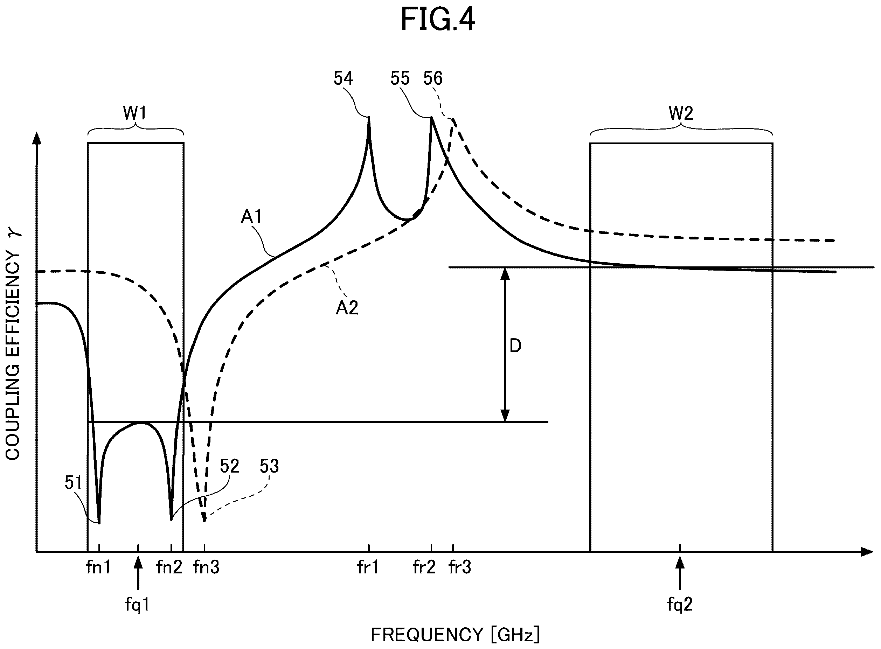

FIG. 4 is a diagram illustrating an example of a frequency characteristic of a coupling efficiency of a filter. The highpass filter 40 has a coupling efficiency characteristic that transmits the control signal S in a first frequency band W1 with a coupling coefficient γ lower than that in a second frequency band W2. The highpass filter 40 has a plurality of notches (in this example, a first notch 51 and a second notch 52) in the first frequency band W1 including a resonant frequency fq1 of the control qubit 10.

The first notch 51 is a frequency characteristic point at which a control signal S1 is minimized at a first notch frequency fn1 included in the first frequency band W1. The second notch 52 is a frequency characteristic point at which the control signal S1 is minimized at a second notch frequency fn2 included in the first frequency band W1. The second notch frequency fn2 is higher than the first notch frequency fn1.

The highpass filter 40 has a frequency characteristic A1 having the first notch 51 and the second notch 52 in the first frequency band W1. Thus, the width of the first frequency band W1 in which the control signal S input to the control qubit 10 is transmitted with the coupling coefficient γ lower than that of the second frequency band W2 can be widened compared to the case of a frequency characteristic A2 having one notch 53 having a notch frequency fn3 in a low frequency band. Because the width of the first frequency band W1 in which the control signal S is transmitted with the coupling coefficient γ lower than that of the second frequency band W2 can be widened, the coupling coefficient characteristic of the highpass filter 40 in the first frequency band W1 can be made to approximate a flat characteristic. As a result, even when the frequency at which the control qubit 10 resonates is shifted due to the manufacturing variations or the like, it is possible to stabilize the operation of the quantum device 100 (cross resonance gating).

In the example illustrated in FIG. 4, the highpass filter 40 has the first notch 51 and the second notch 52 such that a resonance frequency fq1 of the control qubit 10 is interposed between the first notch frequency fn1 and the second notch frequency fn2. In this case, the control qubit 10 resonates in a frequency band interposed between the first notch frequency fn1 and the second notch frequency fn2. Hence, by providing the notches above and below the resonance frequency fq1 of the control qubit 10, it is possible to prevent the coupling efficiency γ at the resonance frequency fq1 from becoming excessively reduced.

FIG. 4 illustrates an example of the frequency characteristic A1 in which the highpass filter 40 has two notches, including the first notch 51 and the second notch 52, in the first frequency band W1. However, the highpass filter 40 may have three or more notches in the first frequency band W1. Thus, it is possible to further widen the width of the first frequency band W1 in which the coupling coefficient γ is reduced more than in the second frequency band W2.

The highpass filter 40 may have a frequency characteristic having one or more resonance points that resonate between the resonance frequency fq1 of the control qubit 10 and the resonance frequency fq2 of the target qubit 20. The example of the frequency characteristic A1 illustrated in FIG. 4 has a first resonance point 54 having a filter resonance frequency fr1 and a second resonance point 55 having a filter resonance frequency fr2, between the resonance frequency fq1 and the resonance frequency fq2. The filter resonance frequency fr1 is higher than the second notch frequency fn2. The filter resonance frequency fr2 is higher than the filter resonance frequency fr1. The frequency characteristic A2 has one resonance point 56 having a filter resonance frequency fr3 between the resonance frequency fq1 and the resonance frequency fq2.

Because the highpass filter 40 has the frequency characteristic A1 that resonates between the resonance frequency fq1 and the resonance frequency fq2, it is possible to increase a coupling efficiency difference D compared to the case where the highpass filter 40 has a frequency characteristic that does not resonate between the resonance frequency fq1 and the resonance frequency fq2. The coupling efficiency difference D represents a difference between the coupling efficiency γ of the highpass filter 40 in the first frequency band W1 and the coupling efficiency γ of the highpass filter 40 in the second frequency band W2. By increasing the coupling efficiency difference D, it is possible to reduce the intensity of the control signal S in the first frequency band W1, even if the intensity of the control signal S in the second frequency band W2 is increased. That is, it is possible to simultaneously increase the quantum gating speed and reduce a decrease in the coherence time.

The highpass filter 40 may have a coupling efficiency characteristic that transmits the control signal S in the first frequency band W1 with a coupling coefficient γ lower than that in the second frequency band W2, by utilizing Fano resonance. By utilizing the Fano resonance, it is possible to easily obtain a frequency characteristic A1 that can secure a large coupling efficiency difference D.

As illustrated in FIG. 3, the highpass filter 40 may include a first filter 41 forming the first notch 51, and a second filter 42 forming the second notch 52. Because each notch is formed by a separate filter, it is possible to improve the accuracy of the first notch frequency fn1 and the second notch frequency fn2. For example, the first filter 41 can implement a frequency characteristic having the first notch 51 and the first resonance point 54 by utilizing the Fano resonance. The second filter 42 can implement a frequency characteristic having the second notch 52 and the second resonance point 55 by utilizing the Fano resonance. The frequency characteristic A1 illustrated in FIG. 4 can be achieved by a combination of the frequency characteristic of the first filter 41 and the frequency characteristic of the second filter 42.

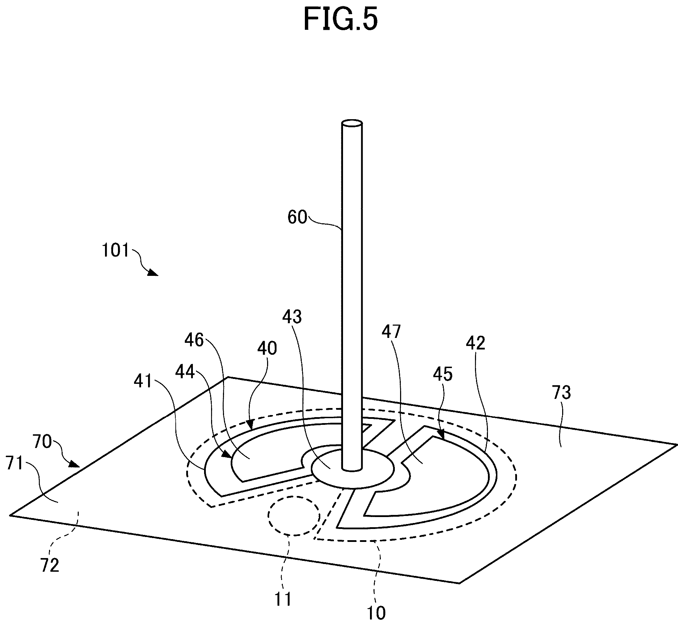

FIG. 5 is a diagram illustrating a configuration example of the quantum device according to a first embodiment. A quantum device 101 illustrated in FIG. 5 is an example of the quantum device 100 described above. The quantum device 101 illustrated in FIG. 5 includes a substrate 70 having a first layer 71 facing a first direction, and a second layer 72 facing a second direction opposite to the first direction. One of the first layer 71 and the second layer 72 is a front surface layer of the substrate 70, and the other of the first layer 71 and the second layer 72 is a rear surface layer of the substrate 70. The substrate 70 is a dielectric substrate on which a predetermined conductor pattern is formed.

A terminal 43 to which the control signal S is input is provided on the first layer 71. A terminal 43 is electrically connected to a coaxial line 60 that transmits the control signal S. The terminal 43 is an electrode, such as a planar terminal pad or the like, for example. The coaxial line 60 is an example of a transmission line, such as a coaxial cable or the like, for example. The coaxial line 60 is an example of the waveguide 31 described above. The control signal S input to the terminal 43 via the coaxial line 60 passes through an inner layer of the substrate 70, and reaches the control qubit 10 provided on the second layer 72. Although not illustrated in FIG. 5, the target qubit 20 coupled to the control qubit 10 is provided on the second layer 72, for example.

Because the quantum device 101 has the configuration in which the control signal S is transmitted from the first layer 71 to the second layer 72, a length of a transmission line for transmitting the control signal S from the terminal 43 to the control qubit 10 is relatively short (approximately equal to a thickness of the substrate 70). For this reason, according to conventional techniques, it is difficult to provide a highpass filter having a coupling efficiency characteristic like the frequency characteristic A1 described above on the transmission line from the terminal 43 to the control qubit 10, due to space constraints.

Accordingly, in the quantum device 101 according to the first embodiment, the highpass filter 40 (more specifically, the first filter 41 and the second filter 42), which utilizes an interference of the Fano resonance for the coupling efficiency characteristic, is provided on the first layer 71. Hence, even in the quantum device 101 having a configuration in which it is difficult to sufficiently secure the length of the transmission line for transmitting the control signal S from the terminal 43 to the control qubit 10, it is easy to form the highpass filter 40 having the frequency characteristic A1 described above.

The first filter 41 and the second filter 42 are provided around the terminal 43. Thus, it easy to form the highpass filter 40 having the frequency characteristic A1 described above that transmits the control signal S input to the control qubit 10 from the terminal 43 with the low coupling coefficient γ. In this example, the second filter 42 is formed so as to oppose the first filter 41 with the terminal 43 interposed therebetween.

The first filter 41 includes a first resonator 44 adjacent to the terminal 43, and the second filter 42 includes a second resonator 45 adjacent to the terminal 43. The first resonator 44 is a high-frequency circuit that forms the first resonance point 54 of the frequency characteristic A1, and the second resonator 45 is a high-frequency circuit that forms the second resonance point 55 of the frequency characteristic A1. The second resonator 45 is formed so as to oppose the first resonator 44 with the terminal 43 interposed therebetween. The first resonator 44 is disposed between the terminal 43 and a ground 73. The second resonator 45 is disposed between the terminal 43 and the ground 73. The ground 73 is formed on the first layer 71.

The first resonator 44 includes a first conductor pattern 46 formed on the first layer 71. The second resonator 45 includes a second conductor pattern 47 formed on the first layer 71. The first conductor pattern 46 and the second conductor pattern 47 are linear conductors formed in a fan-shaped area illustrated in FIG. 4 and folded back a plurality of times, for example.

The control qubit 10 includes a Josephson junction 11 that does not overlap the first resonator 44 and the second resonator 45 in a plan view of the substrate 70. Thus, effects of crosstalk of the first resonator 44 and the second resonator 45 on the Josephson junction 11 can be reduced, and thus, the coherence time (an average time for which the qubit maintains an excited state of "1") of the control qubit 10 can be maintained.

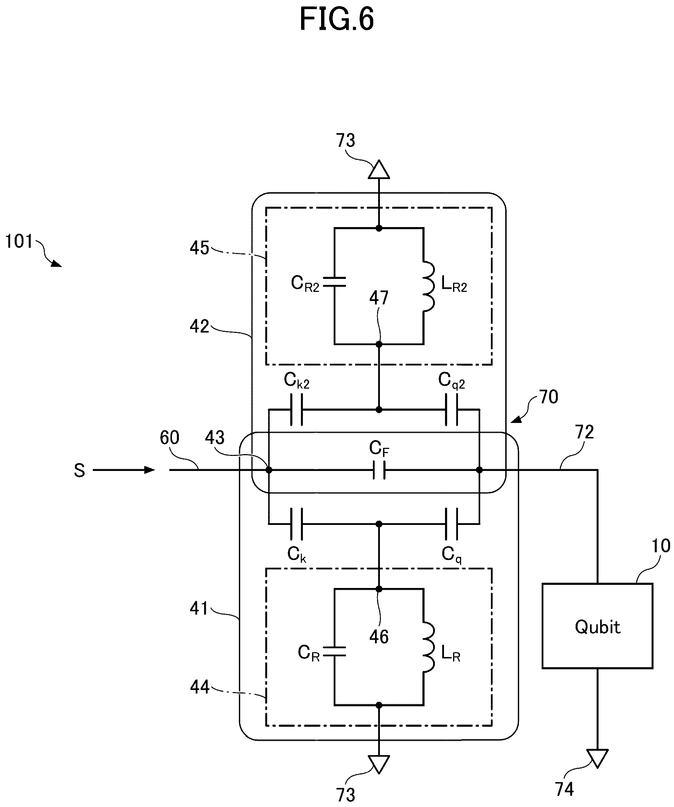

FIG. 6 is an equivalent circuit diagram of the quantum device according to the first embodiment illustrated in FIG. 5. The substrate 70 has a substrate capacitance C_{F} between the terminal 43 and the control qubit 10. The substrate capacitance C_{F} is a coupling capacitance between the terminal 43 and the control qubit 10, and is included in the first filter 41 and the second filter 42.

The first filter 41 includes a first capacitance Cₖ between the terminal 43 and the first conductor pattern 46 of the first resonator 44, and a second capacitance C_{q} between the first conductor pattern 46 of the first resonator 44 and the control qubit 10. That is, the first conductor pattern 46 forms the first capacitance Cₖ between the first conductor pattern 46 and the terminal 43, and forms the second capacitance C_{q} between the first conductor pattern 46 and the control qubit 10. The first notch 51 is formed by a destructive interference (Fano resonance) between a signal transmitted to the control qubit 10 via the first resonator 44 by the first capacitance Cₖ and the second capacitance C_{q} and a signal transmitted directly to the control qubit 10 from the waveguide via the substrate capacitance C_{F}.

The second filter 42 includes a third capacitance Cₖ₂ between the terminal 43 and the second conductor pattern 47 of the second resonator 45, and a fourth capacitance C_{q2} between the second conductor pattern 47 of the second resonator 45 and the control qubit 10. That is, the second conductor pattern 47 forms the third capacitance Cₖ₂ between the second conductor pattern 47 and the terminal 43, and forms the fourth capacitance C_{q2} between second conductor pattern 47 and the control qubit 10. The second notch 52 is formed by a destructive interference between a signal transmitted to the control qubit 10 via the second resonator 45 by the third capacitance Cₖ₂ and the fourth capacitance C_{q2} and a signal transmitted directly to the control qubit 10 from the waveguide via the substrate capacitance C_{F}.

The first resonator 44 includes a fifth capacitance C_{R} between the first conductor pattern 46 and the ground 73, and a first inductor L_{R} between the first conductor pattern 46 and the ground 73. The first resonator 44 is an LC resonator including the fifth capacitance C_{R} and the first inductor L_{R}. The first resonance point 54 is formed by the first resonator 44.

The second resonator 45 includes a sixth capacitance C_{R2} between the second conductor pattern 47 and the ground 73, and a second inductor L_{R2} between the second conductor pattern 47 and the ground 73. The second resonator 45 is an LC resonator including the sixth capacitance C_{R2} and the second inductor L_{R2}. The second resonance point 55 is formed by the second resonator 45.

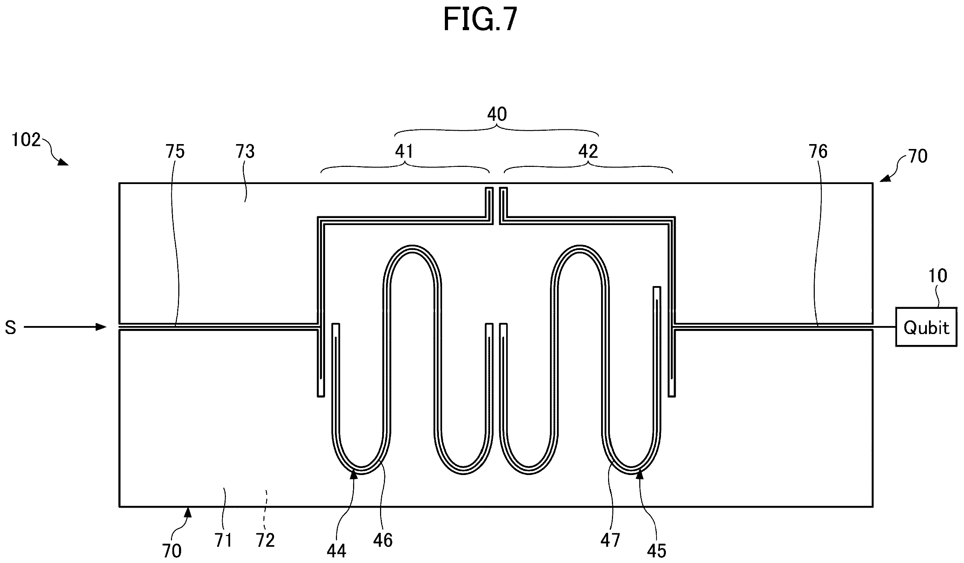

FIG. 7 is a plan view illustrating a configuration example of the quantum device according to a second embodiment. A quantum device 102 illustrated in FIG. 7 is an example of the quantum device 100 described above. The quantum device 102 illustrated in FIG. 7 includes a substrate 70 having an input line 75 to which the control signal S is input and an output line 76 to which the control qubit 10 is connected. The quantum device 102 includes a highpass filter 40 including a plurality of filters (in the example, a first filter 41 and a second filter 42) connected in series between the input line 75 and the output line 76.

The first filter 41 includes a first resonator 44 adjacent to the input line 75, and the second filter 42 includes a second resonator 45 adjacent to the output line 76. The first resonator 44 is a high-frequency circuit that forms a first resonance point 54 of the frequency characteristic A1, and the second resonator 45 is a high-frequency circuit that forms a second resonance point 55 of the frequency characteristic A1. The second resonator 45 is formed so as to face the first resonator 44 with a capacitive coupling interposed therebetween. The first resonator 44 is disposed between the input line 75 and the second resonator 45 so as to be surrounded by a ground 73. The second resonator 45 is disposed between the first resonator 44 and the output line 76 so as to be surrounded by the ground 73. The ground 73 is formed on a first layer 71.

The first resonator 44 includes a first conductor pattern 46 formed on the first layer 71. The second resonator 45 includes a second conductor pattern 47 formed on the first layer 71. The first conductor pattern 46 and the second conductor pattern 47 are linear conductors folded back a plurality of times.

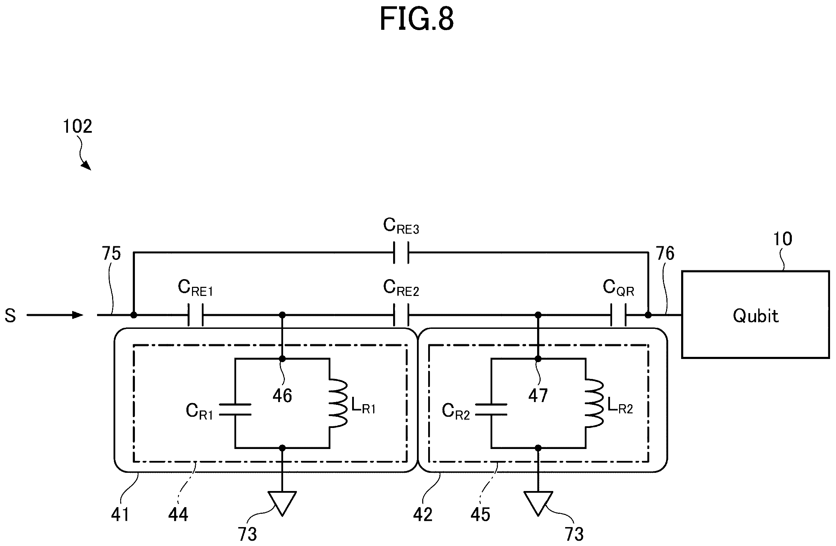

FIG. 8 is an equivalent circuit diagram of the quantum device of the second embodiment illustrated in FIG. 7. The quantum device 102 includes a capacitance C_{RE1} between the input line 75 and the first filter 41, and a capacitance C_{RE2} between the first filter 41 and the second filter 42. The quantum device 102 further includes a capacitance C_{RE3} between the input line 75 and the output line 76 or the control qubit 10, and a capacitance C_{QR} between the second filter 42 and the output line 76 or the control qubit 10. The plurality of notches including the first notch 51 and the second notch 52 are formed by a destructive interference between a signal transmitted from the input line 75 to the output line 76 via the first resonator 44 and the second resonator 45 by the capacitance C_{RE1}, the capacitance C_{RE2}, and the capacitance C_{QR} and a signal transmitted directly to the output line 76 from the input line 75 by the capacitance C_{RE3}.

The first resonator 44 includes a capacitance C_{R} between the first conductor pattern 46 and the ground 73, and a first inductor L_{R} between the first conductor pattern 46 and the ground 73. The first resonator 44 is an LC resonator including the capacitance C_{R} and the first inductor L_{R}. The first resonance point 54 is formed by the first resonator 44.

The second resonator 45 includes a capacitance C_{R2} between the second conductor pattern 47 and the ground 73, and a second inductor L_{R2} between the second conductor pattern 47 and the ground 73. The second resonator 45 is an LC resonator including the capacitance C_{R2} and the second inductor L_{R2}. The second resonance point 55 is formed by the second resonator 45.

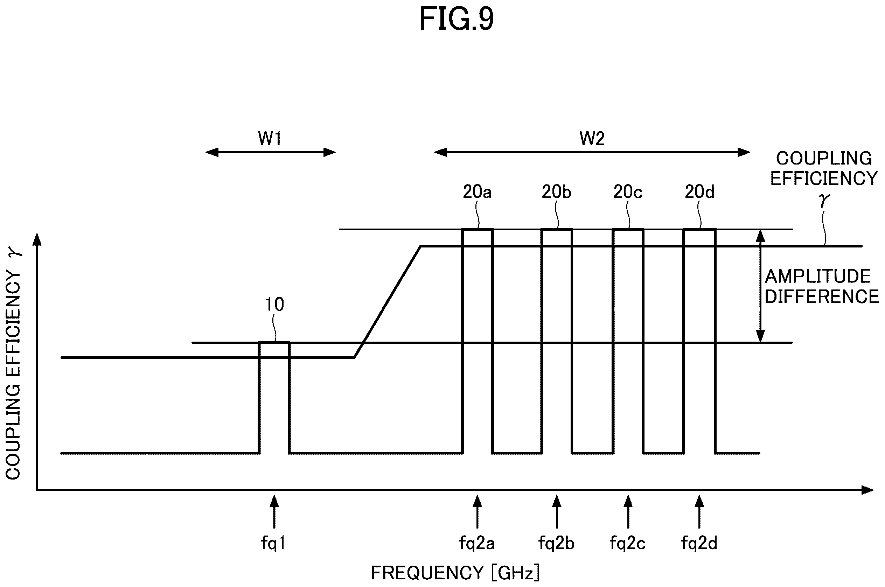

FIG. 9 is a diagram for explaining the frequency characteristic of the coupling efficiency of the filter and the resonance frequency of each qubit. The target qubit 20 may include a plurality of target qubits (in this example, four target qubits 20a, 20b, 20c, and 20d) that resonate at mutually different frequencies in the second frequency band W2.

The control qubit 10 has a resonance frequency fq1 within the first frequency band W1. By providing a plurality of notches in the first frequency band W1, the control signal S input to the control qubit 10 is transmitted in the low frequency band including the resonance frequency fq1 with a coupling coefficient γ lower than that in the second frequency band W2.

On the other hand, the plurality of target qubits 20a, 20b, 20c, and 20d have resonance frequencies fq2a, fq2b, fq2c, and fq2d within the second frequency band W2. The highpass filter 40 has a coupling coefficient γ in the first frequency band W1 lower than a coupling coefficient γ in the second frequency band W2. The plurality of target qubits 20a, 20b, 20c, and 20d resonate at frequencies included in a high frequency band having a flat characteristic in the frequency characteristic of the highpass filter 40.

According to the present disclosure, the quantum gating speed and the coherence time can be secured.

Although the embodiments are numbered with, for example, "first," or "second," the ordinal numbers do not imply priorities of the embodiments. Many other variations and modifications will be apparent to those skilled in the art.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the scope of the invention as defined by the appended claims.

## Claims

1. A quantum device (101) comprising:
a highpass filter (40) having a plurality of notches (51, 52) in a first frequency band (W1) lower than a second frequency band (W2), wherein a coupling efficiency of the highpass filter (40) in the second frequency band (W2) is higher than a coupling efficiency of the highpass filter (40) in the first frequency band (W1);
a first qubit (10) that resonates at a first resonant frequency (fq1) included in the first frequency band (W1); and
a second qubit (20) that resonates at a second resonant frequency (fq2) included in the second frequency band (W2),
wherein the first qubit (10) is input with a signal (S) having a frequency at which the first qubit (10) resonates via the highpass filter (40) to control a state of the first qubit (10) when executing a one-qubit gating, and is input with a signal having a frequency at which the second qubit (20) resonates via the highpass filter (40) to control a state of the second qubit (20) according to a quantum state of the first qubit (10) when executing a two-qubit gating, and
wherein the first qubit (10) is a control qubit, and the second qubit (20) is a target qubit.

2. The quantum device (101) as claimed in claim 1, wherein the highpass filter (40) resonates between the first resonant frequency (fq1) of the first qubit (10) and the second resonant frequency (fq2) of the second qubit (20).

3. The quantum device (101) as claimed in claim 1 or 2, wherein the plurality of notches (51, 52) includes a first notch (51) having a first notch frequency (fn1), and a second notch (52) having a second notch frequency (fn2) higher than the first notch frequency (fn1) and lower than a resonance frequency (fr1, fr2) of the highpass filter (40).

4. The quantum device (101) as claimed in claim 3, wherein the highpass filter (40) includes a first filter (41) forming the first notch (51), and a second filter (42) forming the second notch (52).

5. The quantum device (101) as claimed in claim 4, further comprising:
a substrate (70) including a first layer (71) provided with the first filter (41) and the second filter (42), and a second layer (72) provided with the first qubit (10).

6. The quantum device (101) as claimed in claim 5, wherein:
the first layer (71) is provided with a terminal (43) to which a signal having a frequency at which the first qubit (10) or the second qubit (20) resonates is input, and
the first filter (41) and the second filter (42) are provided around the terminal (43).

7. The quantum device (101) as claimed in claim 6, wherein the second filter (42) opposes the first filter (41) via the terminal (43) interposed between the first filter (41) and the second filter (42).

8. The quantum device (101) as claimed in claim 6 or 7, wherein:
the first filter (41) includes a first resonator (44) in close proximity to the terminal (43), and
the second filter (42) includes a second resonator (45) in close proximity to the terminal (43).

9. The quantum device (101) as claimed in claim 8, wherein the first qubit (10) includes a Josephson junction (11) that does not overlap the first resonator (44) and the second resonator (45) in a plan view of the substrate (70).

10. The quantum device (101) as claimed in claim 8 or 9, wherein:
the first filter (41) includes a first capacitance (Cₖ) between the terminal (43) and the first resonator (44), and a second capacitance (C_{q}) between the first resonator (44) and the first qubit (10), and
the second filter (42) includes a third capacitance (Cₖ₂) between the terminal (43) and the second resonator (45), and a fourth capacitance (C_{q2}) between the second resonator (45) and the first qubit (10).

11. The quantum device (101) as claimed in any one of claims 8 to 10, wherein:
each of the first filter (41) and the second filter (42) includes a coupling capacitance (C_{F}) between the terminal (43) and the first qubit (10), and
an interference between a signal via the first resonator (44) and a signal via the coupling capacitance (C_{F}) forms the first notch (51), and an interference between a signal via the second resonator (45) and the signal via the coupling capacitance (C_{F}) forms the second notch (52).

12. The quantum device (101) as claimed in claim 10, wherein:
the first resonator (44) includes a first conductor pattern (46) that forms the first capacitance (Cₖ) and the second capacitance (C_{q}), a fifth capacitance (C_{R}) between the first conductor pattern (46) and a ground (73), and a first inductor (L_{R}) between the first conductor pattern (46) and the ground (73), and
the second resonator (45) includes a second conductor pattern (47) that forms the third capacitance (Cₖ₂) and the fourth capacitance (C_{q2}), a sixth capacitance (C_{R2}) between the second conductor pattern (47) and the ground (73), and a second inductor (L_{R2}) between the second conductor pattern (47) and the ground (73).

13. The quantum device (101) as claimed in any one of claims 1 to 12, wherein the first qubit (10) resonates in a band between the plurality of notches (51, 52).

14. The quantum device (101) as claimed in any one of claims 1 to 13, wherein the second qubit (20) includes a plurality of qubits that resonate at frequencies different from one another in the second frequency band (W2).

15. The quantum device (101) as claimed in any one of claims 1 to 14, wherein the highpass filter (40) utilizes Fano resonance.

## Patentansprüche

1. Quantenvorrichtung (101), umfassend:
einen Hochpassfilter (40), der eine Vielzahl von Kerben (51, 52) in einem ersten Frequenzband (W1) aufweist, das niedriger als ein zweites Frequenzband (W2) ist, wobei ein Kopplungswirkungsgrad des Hochpassfilters (40) in dem zweiten Frequenzband (W2) höher als ein Kopplungswirkungsgrad des Hochpassfilters (40) in dem ersten Frequenzband (W1) ist;
ein erstes Qubit (10), das bei einer ersten Resonanzfrequenz (fq1) in Resonanz ist, die in dem ersten Frequenzband (W1) eingeschlossen ist; und
ein zweites Qubit (20), das bei einer zweiten Resonanzfrequenz (fq2) in Resonanz ist, die in dem zweiten Frequenzband (W2) eingeschlossen ist,
wobei das erste Qubit (10) mit einem Signal (S) eingegeben wird, das eine Frequenz aufweist, bei der das erste Qubit (10) über den Hochpassfilter (40) in Resonanz ist, um einen Zustand des ersten Qubits (10) zu steuern, wenn ein Ein-Qubit-Gating ausgeführt wird, und mit einem Signal eingegeben wird, das eine Frequenz aufweist, bei der das zweite Qubit (20) über den Hochpassfilter (40) in Resonanz ist, um einen Zustand des zweiten Qubits (20) gemäß einem Quantenzustand des ersten Qubits (10) zu steuern, wenn ein Zwei-Qubit-Gating ausgeführt wird, und
wobei das erste Qubit (10) ein Steuer-Qubit ist und das zweite Qubit (20) ein Ziel-Qubit ist.

2. Quantenvorrichtung (101) nach Anspruch 1, wobei der Hochpassfilter (40) zwischen der ersten Resonanzfrequenz (fq1) des ersten Qubits (10) und der zweiten Resonanzfrequenz (fq2) des zweiten Qubits (20) in Resonanz ist.

3. Quantenvorrichtung (101) nach Anspruch 1 oder 2, wobei die Vielzahl von Kerben (51, 52) eine erste Kerbe (51), aufweisend eine erste Kerbenfrequenz (fn1), und eine zweite Kerbe (52), aufweisend eine zweite Kerbenfrequenz (fn2), die höher als die erste Kerbenfrequenz (fn1) und niedriger als eine Resonanzfrequenz (fr1, fr2) des Hochpassfilters (40) ist, einschließt.

4. Quantenvorrichtung (101) nach Anspruch 3, wobei der Hochpassfilter (40) einen ersten Filter (41), der die erste Kerbe (51) ausbildet, und einen zweiten Filter (42), der die zweite Kerbe (52) ausbildet, einschließt.

5. Quantenvorrichtung (101) nach Anspruch 4, weiter umfassend:
ein Substrat (70), das eine erste Schicht (71), die mit dem ersten Filter (41) und dem zweiten Filter (42) bereitgestellt ist, und eine zweite Schicht (72), die mit dem ersten Qubit (10) bereitgestellt ist, einschließt.

6. Quantenvorrichtung (101) nach Anspruch 5, wobei:
die erste Schicht (71) mit einem Anschluss (43) bereitgestellt ist, in dem ein Signal eingegeben wird, das eine Frequenz aufweist, bei der das erste Qubit (10) oder das zweite Qubit (20) in Resonanz ist, und
der erste Filter (41) und der zweite Filter (42) um den Anschluss (43) herum bereitgestellt sind.

7. Quantenvorrichtung (101) nach Anspruch 6, wobei der zweite Filter (42) dem ersten Filter (41) über den Anschluss (43) gegenüberliegt, der zwischen dem ersten Filter (41) und dem zweiten Filter (42) angeordnet ist.

8. Quantenvorrichtung (101) nach Anspruch 6 oder 7, wobei:
der erste Filter (41) einen ersten Resonator (44) in unmittelbarer Nähe des Anschlusses (43) einschließt, und
der zweite Filter (42) einen zweiten Resonator (45) in unmittelbarer Nähe des Anschlusses (43) einschließt.

9. Quantenvorrichtung (101) nach Anspruch 8, wobei das erste Qubit (10) einen Josephson-Übergang (11) einschließt, der den ersten Resonator (44) und den zweiten Resonator (45) in einer Draufsicht auf das Substrat (70) nicht überlappt.

10. Quantenvorrichtung (101) nach Anspruch 8 oder 9, wobei:
der erste Filter (41) eine erste Kapazität (Cₖ) zwischen dem Anschluss (43) und dem ersten Resonator (44) und eine zweite Kapazität (C_{q}) zwischen dem ersten Resonator (44) und dem ersten Qubit (10) einschließt, und
der zweite Filter (42) eine dritte Kapazität (Cₖ₂) zwischen dem Anschluss (43) und dem zweiten Resonator (45) und eine vierte Kapazität (C_{q2}) zwischen dem zweiten Resonator (45) und dem ersten Qubit (10) einschließt.

11. Quantenvorrichtung (101) nach einem der Ansprüche 8 bis 10, wobei:
jeder aus dem ersten Filter (41) und dem zweiten Filter (42) eine Kopplungskapazität (C_{F}) zwischen dem Anschluss (43) und dem ersten Qubit (10) einschließt, und
eine Interferenz zwischen einem Signal über den ersten Resonator (44) und einem Signal über die Kopplungskapazität (C_{F}) die erste Kerbe (51) ausbildet, und eine Interferenz zwischen einem Signal über den zweiten Resonator (45) und dem Signal über die Kopplungskapazität (C_{F}) die zweite Kerbe (52) ausbildet.

12. Quantenvorrichtung (101) nach Anspruch 10, wobei:
der erste Resonator (44) ein erstes Leitermuster (46), das die erste Kapazität (Cₖ) und die zweite Kapazität (C_{q}) ausbildet, eine fünfte Kapazität (C_{R}) zwischen dem ersten Leitermuster (46) und einer Masse (73) und eine erste Induktivität (L_{R}) zwischen dem ersten Leitermuster (46) und der Masse (73) einschließt, und
der zweite Resonator (45) ein zweites Leitermuster (47), das die dritte Kapazität (Cₖ₂) und die vierte Kapazität (C_{q2}) ausbildet, eine sechste Kapazität (C_{R2}) zwischen dem zweiten Leitermuster (47) und der Masse (73) und eine zweite Induktivität (L_{R2}) zwischen dem zweiten Leitermuster (47) und der Masse (73) einschließt.

13. Quantenvorrichtung (101) nach einem der Ansprüche 1 bis 12, wobei das erste Qubit (10) in einem Band zwischen der Vielzahl von Kerben (51, 52) in Resonanz ist.

14. Quantenvorrichtung (101) nach einem der Ansprüche 1 bis 13, wobei das zweite Qubit (20) eine Vielzahl von Qubits einschließt, die bei voneinander verschiedenen Frequenzen im zweiten Frequenzband (W2) in Resonanz sind.

15. Quantenvorrichtung (101) nach einem der Ansprüche 1 bis 14, wobei der Hochpassfilter (40) die Fano-Resonanz nutzt.

## Revendications

1. Dispositif quantique (101) comprenant :
un filtre passe-haut (40) présentant une pluralité d'encoches (51, 52) dans une première bande de fréquence (W1) inférieure à une deuxième bande de fréquence (W2), dans lequel une efficacité de couplage du filtre passe-haut (40) dans la deuxième bande de fréquence (W2) est supérieure à une efficacité de couplage du filtre passe-haut (40) dans la première bande de fréquence (W1) ;
un premier qubit (10) qui résonne à une première fréquence de résonance (fq1) incluse dans la première bande de fréquence (W1) ; et
un deuxième qubit (20) qui résonne à une deuxième fréquence de résonance (fq2) incluse dans la deuxième bande de fréquence (W2),
dans lequel le premier qubit (10) reçoit en entrée un signal (S) présentant une fréquence à laquelle le premier qubit (10) résonne via le filtre passe-haut (40) pour commander un état du premier qubit (10) lors de la mise en œuvre d'un déclenchement à un qubit, et reçoit en entrée un signal présentant une fréquence à laquelle le deuxième qubit (20) résonne via le filtre passe-haut (40) pour commander un état du deuxième qubit (20) selon un état quantique du premier qubit (10) lors de la mise en œuvre d'un déclenchement à deux qubits, et
dans lequel le premier qubit (10) est un qubit de commande et le deuxième qubit (20) est un qubit cible.

2. Dispositif quantique (101) selon la revendication 1, dans lequel le filtreç passe-haut (40) résonne entre la première fréquence de résonance (fq1) du premier qubit (10) et la deuxième fréquence de résonance (fq2) du deuxième qubit (20).

3. Dispositif quantique (101) selon la revendication 1 ou la revendication 2, dans lequel la pluralité d'encoches (51, 52) inclut une première encoche (51) présentant une première fréquence d'encoche (fn1) et une deuxième encoche (52) présentant une deuxième fréquence d'encoche (fn2) supérieure à la première fréquence d'encoche (fn1) et inférieure à une fréquence de résonance (fr1, fr2) du filtre passe-haut (40).

4. Dispositif quantique (101) selon la revendication 3, dans lequel le filtre passe-haut (40) inclut un premier filtre (41) formant la première encoche (51) et un deuxième filtre (42) formant la deuxième encoche (52).

5. Dispositif quantique (101) selon la revendication 4, comprenant en outre :
un substrat (70) incluant une première couche (71) munie du premier filtre (41) et du deuxième filtre (42) et une deuxième couche (72) munie du premier qubit (10).

6. Dispositif quantique (101) selon la revendication 5, dans lequel :
la première couche (71) est munie d'une terminaison (43) à laquelle un signal présentant une fréquence à laquelle le premier qubit (10) ou le deuxième qubit (20) résonne est appliquée en entrée et
le premier filtre (41) et le deuxième filtre (42) sont fournis autour de la terminaison (43).

7. Dispositif quantique (101) selon la revendication 6, dans lequel le deuxième filtre (42) est opposé au premier filtre (41) via la terminaison (43) interposée entre le premier filtre (41) et le deuxième filtre (42).

8. Dispositif quantique (101) selon la revendication 6 ou la revendication 7, dans lequel :
le premier filtre (41) inclut un premier résonateur (44) à proximité immédiate de la terminaison (43), et
le deuxième filtre (42) inclut un deuxième résonateur (45) à proximité immédiate de la terminaison (43).

9. Dispositif quantique (101) selon la revendication 8, dans lequel le premier qubit (10) inclut une jonction Josephson (11) qui ne chevauche pas le premier résonateur (44) et le deuxième résonateur (45) dans une vue en plan du substrat (70).

10. Dispositif quantique (101) selon la revendication 8 ou la revendication 9, dans lequel :
le premier filtre (41) inclut une première capacité (Cₖ) entre la terminaison (43) et le premier résonateur (44), et une deuxième capacité (C_{q}) entre le premier résonateur (44) et le premier qubit (10), et
le deuxième filtre (42) inclut une troisième capacité (C_{R2}) entre la terminaison (43) et le deuxième résonateur (45), et une quatrième capacité (C_{q2}) entre le deuxième résonateur (45) et le premier qubit (10).

11. Dispositif quantique (101) selon l'une quelconque des revendications 8 à 10, dans lequel :
chacun du premier filtre (41) et du deuxième filtre (42) inclut une capacité de couplage (C_{F}) entre la terminaison (43) et le premier qubit (10), et
une interférence entre un signal via le premier résonateur (44) et un signal via la capacité de couplage (C_{F}) forme la première encoche (51), et une interférence entre un signal via le deuxième résonateur (45) et le signal via la capacité de couplage (C_{F}) forme la deuxième encoche (52).

12. Dispositif quantique (101) selon la revendication 10, dans lequel :
le premier résonateur (44) inclut un premier motif conducteur (46) qui forme la première capacité (Cₖ) et la deuxième capacité (C_{q}), une cinquième capacité (C_{R}) entre le premier motif conducteur (46) et une terre (73), et une première inductance (Lᵣ) entre le premier motif conducteur (46) et la terre 73), et
le deuxième résonateur (45) inclut un deuxième motif conducteur (47) qui forme la troisième capacité (Cₖ₂) et la quatrième capacité (C_{q2}), une sixième capacité (C_{R2}) entre le deuxième motif conducteur (47) et la terre (73), et une deuxième inductance (Lᵣ₂) entre le deuxième motif conducteur (47) et la terre (73).

13. Dispositif quantique (101) selon l'une quelconque des revendications 1 à 12, dans lequel le premier qubit (10) résonne dans une bande entre la pluralité d'encoches (51, 52).

14. Dispositif quantique (101) selon l'une quelconque des revendications 1 à 13, dans lequel le deuxième qubit (20) inclut une pluralité de qubits qui résonnent à des fréquences différentes les unes des autres dans la deuxième bande de fréquence (W2).

15. Dispositif quantique (101) selon l'une quelconque des revendications 1 à 14, dans lequel le filtre passe-haut (40) utilise une résonance de Fano.
